# EUROPÄISCHE PATENTSCHRIFT

(11) **EP 4 256 912 B1**
(45) Veröffentlichungstag und Bekanntmachung des Hinweises auf die Patenterteilung: **18.09.2024**
(21) Anmeldenummer: 22705713.0
(22) Anmeldetag: 05.02.2022
(51) Int. Cl.: H05K 7/20

(54) **VERFAHREN UND SYSTEM ZUM KÜHLEN EINER VORRICHTUNG**
METHOD AND SYSTEM FOR COOLING AN APPARATUS
PROCÉDÉ ET SYSTÈME DE REFROIDISSEMENT D'UN APPAREIL

(30) Priorität: 15.02.2021 DE 102021000757
(43) Veröffentlichungstag der Anmeldung: 11.10.2023
(73) Patentinhaber: Knopf, Harry, 50672 Köln (DE)
(72) Erfinder: Knopf, Harry, 50672 Köln (DE)
(74) Vertreter: Koch, Theodor
(86) Internationale Anmeldenummer: PCT/DE2022/000012
(87) Internationale Veröffentlichungsnummer: WO 2022/171227

(56) Entgegenhaltungen:
- EP-A2- 2 138 775
- WO-A1-2019/086523
- CN-A- 108 448 944

## Beschreibung

Die Erfindung betrifft ein Verfahren zum Kühlen einer Vorrichtung. Bei dem Verfahren stellt eine kontinuierlich betriebene erste Vorrichtung betriebsbedingt einen ersten Wärmestrom bereit. Eine Umgebung der ersten Vorrichtung nimmt den ersten Wärmestrom auf. Eine von der ersten Vorrichtung verschiedene zweite Vorrichtung stellt betriebsbedingt einen zweiten Wärmestrom bereit. Ein die zweite Vorrichtung und die erste Vorrichtung thermisch koppelndes Wärmeleitsystem leitet zum Kühlen der zweiten Vorrichtung den zweiten Wärmestrom zu der ersten Vorrichtung. Die erste Vorrichtung nimmt den zweiten Wärmestrom auf. Ferner betrifft die Erfindung ein System zum Kühlen einer Vorrichtung.

Die Erfindung ist in den unabhängigen Ansprüchen spezifiziert. Die abhängigen Ansprüche geben vorteilhafte Weiterbildungen der Erfindung an.

Kühlverfahren sind in unterschiedlichen Ausgestaltungen bekannt und dienen dazu, einen von einer Vorrichtung betriebsbedingt erzeugten Wärmestrom aufzunehmen. Durch das Aufnehmen des Wärmestroms, welcher auch als Wärmeleistung bezeichnet wird, wird eine Wärme, d.h. Verlustwärme, von der Vorrichtung abgeführt oder abtransportiert, was mit einem Sinken einer Betriebstemperatur der Vorrichtung einhergeht. Ein Absenken der Betriebstemperatur der Vorrichtung durch Abführen der Verlustwärme der Vorrichtung wird gewöhnlich als Kühlen der Vorrichtung bezeichnet.

Jede Vorrichtung, welche aufgrund einer hohen Verlustleistung, zumeist einer hohen elektrischen Verlustleistung, einen starken Wärmestrom bereitstellt, wird nicht optimal, insbesondere nicht mit einem maximalen Wirkungsgrad, betrieben oder verschleißt schnell oder kann sogar sofort zerstört werden, wenn sie oberhalb einer individuellen maximalen Betriebstemperatur betrieben wird. Deshalb ist für einen optimalen Betrieb, eine lange Lebensdauer oder einen Dauerbetrieb einer Vorrichtung ein Kühlen der Vorrichtung während des Betriebs unabdingbar.

JP 2012-42105 A beschreibt ein Kühlverfahren für ein Rechenzentrum, welches einen von dem Rechenzentrum bereitgestellten Wärmestrom zum Erhitzen von Wasser in einem Heißwassertank verwendet. WO 2019/086 523 A1 lehrt, zum Heizen eines Gewächshauses, einer Fabrikhalle, eines Wohngebäudes, eines Schwimmbads oder einer Lagerhalle einen von einem Rechenzentrum bereitgestellten Wärmestrom zu verwenden. CN 108 448 944 A schlägt vor, aus einem von einem Rechenzentrum bereitgestellten Wärmestrom mittels eines thermoelektrischen Generators eine elektrische Energie zu gewinnen.

DE 245 7951 A1 offenbart ein Kühlverfahren für einen Computer, welches einen von dem Computer bereitgestellten Wärmestrom zum Erwärmen von Wasser in einem Verbraucherkreis oder einer Zentralheizungsanlage verwendet. Auch in EP 2 138 775 A2 wird ein Erwärmen von Wasser beschrieben, welches mittels eines von einem Pufferspeicher bereitgestellten Wärmestroms erfolgt.

Die von der Vorrichtung mittels des Kühlens abgeführte Wärme, genauer als eine thermische Energie oder eine Wärmeenergie bezeichnet, ist wie jede Form von Energie erhalten, d.h. kann zwar umgewandelt, aber nicht vernichtet werden. Sie gelangt deshalb unweigerlich als ein kontinuierlicher Wärmeeintrag in eine Umgebung der Vorrichtung und damit in die Umwelt, wo sie zu einer unerwünschten Klimaerwärmung beitragen kann.

Dieser ungünstige Umstand wird auch nicht dadurch geändert, dass der von der Vorrichtung betriebsbedingt bereitgestellte Wärmestrom über ein Wärmeleitsystem zu einer weiteren Vorrichtung geleitet wird und von der weiteren Vorrichtung vollständig oder im Wesentlichen vollständig, d.h. nahezu vollständig, aufgenommen wird. In diesem Fall gelangt der von der Vorrichtung bereitgestellte Wärmestrom als ein kontinuierlicher Wärmeeintrag lediglich in eine Umgebung der weiteren Vorrichtung anstelle der Umgebung der Vorrichtung und trägt schließlich in demselben Maße zu der Klimaerwärmung bei.

Es ist daher eine Aufgabe der Erfindung, ein Verfahren zum Kühlen einer Vorrichtung vorzuschlagen, welches eine thermische Belastung der Umwelt infolge eines von der gekühlten Vorrichtung verursachten Wärmeeintrags in die Umwelt vermeidet oder zumindest stark verringert. Ferner ist es eine Aufgabe der Erfindung, ein System zum Kühlen einer Vorrichtung bereitzustellen.

Ein Gegenstand der Erfindung ist ein Verfahren zum Kühlen einer Vorrichtung, bei dem eine kontinuierlich betriebene erste Vorrichtung betriebsbedingt einen ersten Wärmestrom bereitstellt, eine Umgebung der ersten Vorrichtung den ersten Wärmestrom aufnimmt, eine von der ersten Vorrichtung verschiedene zweite Vorrichtung betriebsbedingt einen zweiten Wärmestrom bereitstellt, ein die zweite Vorrichtung und die erste Vorrichtung thermisch koppelndes Wärmeleitsystem zum Kühlen der zweiten Vorrichtung den zweiten Wärmestrom zu der ersten Vorrichtung leitet und die erste Vorrichtung den zweiten Wärmestrom vollständig oder im Wesentlichen vollständig aufnimmt. Im Sinne der Erfindung sind die zweite Vorrichtung eine insbesondere kühlbedürftige Wärmequelle und die erste Vorrichtung eine kühlfähige Wärmesenke. Das vollständige oder im Wesentlichen vollständige Aufnehmen ist als ein Aufnehmen mit Ausnahme eines unvermeidbaren thermischen Verlusts zu verstehen.

In dem Wärmeleitsystem strömt zumindest ein Fluid, welches den zweiten Wärmestrom von der zweiten Vorrichtung zu der ersten Vorrichtung leitet. Dabei wird kein in dem Wärmeleitsystem strömendes Fluid komprimiert oder expandiert. Wenn in dem Wärmeleitsystem ein flüssiges Fluid strömt, ist ein Komprimieren oder Expandieren des Fluids wegen der Inkompressibilität von Flüssigkeit praktisch ausgeschlossen. Wenn in dem Wärmeleitsystem ein gasförmiges Fluid strömt, ist ein Komprimieren oder Expandieren des des Fluids zwar möglich. Jedoch betrifft die Erfindung auch in diesem Fall ausschließlich solche Wärmeleitsysteme, welche das gasförmige Fluid weder komprimieren noch expandieren.

Bevorzugt wird mit dem Verfahren eine zweite Vorrichtung gekühlt, welche kontinuierlich betrieben wird und einen zeitlich konstanten oder im Wesentlichen konstanten und insbesondere starken Wärmestrom bereitstellt. Das Verfahren ist also für eine in einem Dauerbetrieb betriebene und infolge einer hohen Wärmeleistung stark kühlbedürftige zweite Vorrichtung besonders geeignet, welche die Umwelt ohne Weiteres aufgrund eines kontinuierlich hohen Wärmeeintrags in eine Umgebung der zweiten Vorrichtung thermisch stark belastet.

Es wird angemerkt, dass die erste Vorrichtung aufgrund des aufgenommenen zweiten Wärmestroms ohne Weiteres zwangsläufig bei einer höheren Betriebstemperatur, d.h. in einem neuen Betriebspunkt, betrieben wird, welcher von einem ursprünglichen Betriebspunkt der ersten Vorrichtung, d.h. einem Betriebspunkt ohne ein Aufnehmen des zweiten Wärmestroms, verschieden ist. Ein Betreiben der ersten Vorrichtung in dem neuen Betriebspunkt muss daher mit für die erste Vorrichtung geltenden Vorschriften oder von der ersten Vorrichtung zu erfüllenden Normen konform sein.

Bei dem erfindungsgemäßen Verfahren wird als die erste Vorrichtung eine Vorrichtung verwendet, welche eine betriebsbedingte Leistungsaufnahme automatisch korrespondierend zu dem zweiten Wärmestrom verringert. Durch das Verringern der betriebsbedingten Leistungsaufnahme kompensiert die erste Vorrichtung den aufgenommenen zweiten Wärmestrom automatisch. Insbesondere kann eine vorhandene Vorrichtung mit einer automatischen Kompensationsfähigkeit für einen aufgenommenen externen Wärmestrom als die erste Vorrichtung verwendet werden, was mit einer wirtschaftlich besonders günstigen Anwendung des Verfahrens einhergeht. Allerdings kann die erste Vorrichtung auch zugunsten des Verfahrens errichtet werden.

Zudem geht die verringerte Leistungsaufnahme der ersten Vorrichtung mit einem geringeren Energieverbrauch der ersten Vorrichtung einher. Entsprechend weniger Energie muss für den Betrieb der ersten Vorrichtung bereitgestellt werden, was ebenfalls mit einer verringerten Umweltbelastung, insbesondere einem verringerten Wärmeeintrag in die Umwelt, einhergeht. Ein Wärmeeintrag in die Umwelt wird also dank dem Verfahren sowohl unmittelbar - durch Kompensieren des zweiten Wärmestroms - als auch mittelbar - durch eine geringere Leistungsaufnahme der ersten Vorrichtung - verringert.

Optimalerweise wird eine erste Vorrichtung verwendet, deren erster Wärmestrom zumindest die Stärke des zweiten Wärmestroms aufweist. Unter dieser Voraussetzung kann der zweite Wärmestrom vollständig oder zumindest im Wesentlichen vollständig von der ersten Vorrichtung kompensiert werden, d.h. von dem ersten Wärmestrom umfasst sein. Der aufgenommene zweite Wärmestrom lässt in diesem Fall den ersten Wärmestrom unverändert. Mit anderen Worten erhöht sich der von der ersten Vorrichtung bereitgestellte erste Wärmestrom nicht infolge des Aufnehmens des zweiten Wärmestroms. Auf diese Weise brauchen eine Umgebung der zweiten Vorrichtung keinen oder im Wesentlichen keinen, d.h. nahezu keinen, Wärmestrom und die Umgebung der ersten Vorrichtung keinen stärkeren ersten Wärmestrom als ohne einen Betrieb der zweiten Vorrichtung aufzunehmen. Entsprechend wird die zweite Vorrichtung effektiv ohne eine thermische Belastung der Umwelt betrieben, wodurch einer Klimaerwärmung entgegengewirkt wird.

Wenn dagegen eine erste Vorrichtung verwendet wird, deren erster Wärmestrom eine geringere Stärke als der aufgenommene zweite Wärmestrom aufweist, verstärkt sich der erste Wärmestrom nur um eine Stärkedifferenz zwischen dem zweiten Wärmestrom und dem ersten Wärmestrom, d.h. der effektive Wärmeeintrag der zweiten Vorrichtung in die Umwelt wird immerhin um den ursprünglichen Wärmeeintrag der ersten Vorrichtung verringert. Entsprechend wird die zweite Vorrichtung effektiv mit einer geringeren thermischen Belastung der Umwelt betrieben, wodurch einer Klimaerwärmung - wenn auch in geringerem Maße - ebenfalls entgegengewirkt wird.

Erfindungsgemäß wird als die erste Vorrichtung ein Trinkwassernetz verwendet. Das Trinkwassernetz wird kontinuierlich betrieben und umfasst zumindest ein Trinkwasser, d.h. ein zum Trinken geeignetes Wasser, bereitstellendes Wasserwerk und ein sich ausgehend von dem Wasserwerk zu einer Mehrzahl von Verbrauchsstellen erstreckendes Leitungssystem, welches das von dem Wasserwerk bereitgestellte Trinkwasser zu den Verbrauchsstellen leitet. In vielen Fällen umfasst ein Verbrauchen des Trinkwassers ein Erwärmen des Trinkwassers an den Verbrauchsstellen, beispielsweise in einer Heizungsanlage für ein Gebäude oder mittels eines in einem Gebäude angeordneten Durchlauferhitzers, auf eine bestimmte Verbrauchstemperatur. Ein dezentraler Energieverbrauch für das Erwärmen des Trinkwassers an den Verbrauchsstellen gehört zu einer betriebsbedingten Leistungsaufnahme des Trinkwassernetzes.

Nach dem Verbrauchen des Trinkwassers, beispielsweise einem Baden, Duschen, Spülen oder Waschen in privaten Haushalten, wird das Trinkwasser als ein erwärmtes Abwasser durch ein Kanalsystem zu einer Kläranlage geleitet. Dasselbe trifft entsprechend für ein industrielles Verbrauchen des Trinkwassers zu.

Die Kläranlage stellt wegen des erwärmten Abwassers einen Wärmestrom bereit, welcher von einer Umgebung der Kläranlage aufgenommen wird. Der betriebsbedingte Wärmeeintrag des Trinkwassernetzes in die Umwelt erfolgt also schließlich zumindest im Wesentlichen durch die Kläranlage.

Wenn das Trinkwassernetz ein infolge des Aufnehmens des zweiten Wärmestroms erwärmtes Trinkwasser an den Verbrauchsstellen bereitstellt, verbraucht das Erwärmen des Trinkwassers an den Verbrauchsstellen auf die bestimmte Verbrauchstemperatur eine entsprechend geringere Energie, was die betriebsbedingte Leistungsaufnahme des Trinkwassernetzes automatisch verringert.

Für das Trinkwassernetz, insbesondere das Wasserwerk, gelten im Allgemeinen bestimmte Vorschriften betreffend eine Temperatur des bereitgestellten Trinkwassers.

Beispielsweise kann es vorgeschrieben sein, dass die Temperatur des von dem Wasserwerk verarbeiteten und bereitgestellten Trinkwassers in einem Bereich zwischen 6 °C und 18 °C liegen soll und maximal 20 °C betragen darf. In vielen Fällen beträgt eine Zulauftemperatur des zu dem Wasserwerk strömenden Wassers weniger als 10 °C. Das Trinkwassernetz kann daher mit einer höheren Betriebstemperatur, d.h. in einem neuen Betriebspunkt, betrieben werden, ohne geltende Vorschriften zu verletzen. Wenn das Trinkwassernetz zum Kühlen beispielsweise eines Rechenzentrums verwendet wird, ist ein neuer Betriebspunkt realistisch, welcher lediglich ca. 0.5 °C über dem ursprünglichen Betriebspunkt und weiterhin deutlich innerhalb des vorgeschriebenen Bereichs liegt.

Das Trinkwassernetz ist wegen einer hohen spezifischen Wärmekapazität von Wasser und dank einer großen kontinuierlich verarbeiteten und bereitgestellten Menge von Wasser als die erste Vorrichtung besonders geeignet. Zudem ist das Trinkwassernetz gewöhnlich vorhanden und braucht zugunsten des Verfahrens nicht errichtet zu werden.

Weiterhin erfindungsgemäß stellt als die zweite Vorrichtung ein Rechenzentrum den zweiten Wärmestrom bereit. Ein Rechenzentrum ist für einen Dauerbetrieb ausgelegt, weist eine äußerst hohe Verfügbarkeit auf und wird bestimmungsgemäß kontinuierlich betrieben. Das Rechenzentrum umfasst eine große Mehrzahl von IT-Komponenten, insbesondere Prozessoren (Central Processing Unit, CPU), Datenspeicher, Netzwerkkomponenten und dergleichen, welche während des bestimmungsgemäßen Betriebs des Rechenzentrums in der Summe eine äußerst hohe elektrische Leistungsaufnahme und eine entsprechend hohe elektrische Verlustleistung aufweisen.

Aufgrund der elektrischen Verlustleistung erwärmen sich die IT-Komponenten stark und müssen daher ebenso stark gekühlt werden. Ein Kühlen der IT-Komponenten erfolgt üblicherweise mittels eines strömenden Kühlfluids, beispielsweise eines strömenden Kühlgases wie Luft oder einer strömenden Kühlflüssigkeit wie Wasser. Das strömende Kühlfluid nimmt eine Wärme der IT-Komponenten auf und stellt diese als den Wärmestrom des Rechenzentrums bereit. Wenn das Kühlfluid in eine Umgebung des Rechenzentrums geleitet wird, nimmt die Umgebung des Rechenzentrums den von dem Kühlfluid aufgenommenen und abgeführten Wärmestrom auf. Angesichts der Größe des kontinuierlichen Wärmeeintrags bereits eines einzelnen Rechenzentrums in die Umwelt und zugleich der großen und weiter zunehmenden Mehrzahl und Flächendichte von Rechenzentren weltweit ist ein ökologischer Nutzen für die Umwelt besonders hoch, wenn das Rechenzentrum als die zweite Vorrichtung verwendet wird.

Ein neues Rechenzentrum kann vorteilhaft benachbart zu einem Wasserwerk eines Trinkwassernetzes errichtet werden, um eine von dem Wärmeleitsystem überbrückte räumliche Entfernung zu verringern.

Vorteilhaft leitet ein in einem geschlossenen zweiten Kreislauf des Wärmeleitsystems strömendes zweites Fluid den zweiten Wärmestrom von der zweiten Vorrichtung zu einer zweiten Seite eines Wärmeübertragers des Wärmeleitsystems und leitet ein in einem von dem zweiten Kreislauf separaten geschlossenen ersten Kreislauf des Wärmeleitsystems strömendes erstes Fluid den zweiten Wärmestrom von einer ersten Seite des Wärmeübertragers zu der ersten Vorrichtung. Das Wärmeleitsystem kann zwei voneinander fluidgetrennte geschlossene Kreisläufe umfassen, in welchen jeweils ein Fluid strömt, insbesondere zirkuliert. Jeder Kreislauf umfasst eine Mehrzahl von Rohrleitungen und kann eine Mehrzahl von Unterkreisläufen umfassen.

Jedes Fluid kann Wasser umfassen oder aus Wasser bestehen. Wasser weist eine hohe spezifische Wärmekapazität auf und ist dank der hohen spezifischen Wärmekapazität als Fluid besonders geeignet. Jedoch können auch andere Flüssigkeiten oder Gase als das erste Fluid oder das zweite Fluid verwendet werden. Insbesondere kann das in dem ersten Kreislauf strömende Fluid von dem in dem zweiten Kreislauf strömenden Fluid verschieden sein.

Das Wärmeleitsystem umfasst vorteilhaft ferner einen Wärmeübertrager, welcher auch als Wärmetauscher bezeichnet werden kann und beispielsweise als ein Rohrbündelwärmetauscher ausgebildet ist. Der Wärmeübertrager bewirkt eine indirekte Wärmeübertragung zwischen dem ersten Kreislauf und dem zweiten Kreislauf und stellt eine stoffliche Trennung der beiden Fluide sicher. Mit anderen Worten gelangt das in dem ersten Kreislauf strömende erste Fluid nicht in den zweiten Kreislauf und gelangt das in dem zweiten Kreislauf strömende zweite Fluid nicht in den ersten Kreislauf. Lediglich wird ein von dem zweiten Fluid bereitgestellter Wärmestrom von dem ersten Fluid aufgenommen. Anders gesagt wird das zweite Fluid mittels des Wärmeübertragers durch das erste Fluid gekühlt bzw. das erste Fluid mittels des Wärmeübertragers durch das zweite Fluid erwärmt.

In günstigen Ausführungsformen strömt das zweite Fluid in einer Normalbetriebsart des Wärmeleitsystems von der zweiten Vorrichtung und von der zweiten Seite des Wärmeübertragers zu einem thermoelektrischen Generator des Wärmeleitsystems und von dem thermoelektrischen Generator zu der zweiten Seite des Wärmeübertragers, erzeugt der thermoelektrische Generator mittels einer Temperaturdifferenz zwischen einer ersten Eingangstemperatur des zweiten Fluids und einer zweiten Eingangstemperatur des zweiten Fluids eine elektrische Leistung und stellt der thermoelektrische Generator die erzeugte elektrische Leistung zum Betreiben des Wärmeleitsystems und/oder der zweiten Vorrichtung bereit. Das Wärmeleitsystem kann einen thermoelektrischen Generator umfassen. Kurz gesagt, wird mittels des thermoelektrischen Generators ein von der zweiten Vorrichtung erzeugter Temperaturgradient, d.h. die Temperaturdifferenz, zum Erzeugen einer elektrischen Energie verwendet. Der thermoelektrische Generator versorgt das Wärmeleitsystem und/oder die zweite Vorrichtung mit einem elektrischen Strom, wodurch ein Verbrauch des Wärmeleitsystems und/oder der zweiten Vorrichtung von externer Energie verringert wird. Der verringerte Verbrauch von externer Energie geht mit einer verringerten Umweltbelastung der zweiten Vorrichtung und/oder des Wärmeleitsystems einher.

Der thermoelektrische Generator kann die elektrische Energie mittels des Seebeck-Effekts, des Peltier-Effekts und/oder des Thomson-Effekts erzeugen.

Vorteilhaft strömt das zweite Fluid von der zweiten Vorrichtung zu einer einen dritten Wärmestrom bereitstellenden Solarthermieanlage des Wärmeleitsystems und von der Solarthermieanlage zu dem thermoelektrischen Generator und erhöht die Solarthermieanlage die Arbeitstemperatur und vergrößert die Solarthermieanlage die Temperaturdifferenz. Das Wärmeleitsystem kann eine Solarthermieanlage umfassen. Dank der mittels der Solarthermieanlage vergrößerten Temperaturdifferenz erzeugt der thermoelektrische Generator mehr elektrische Energie. Auf diese Weise wird ein Verbrauch der zweiten Vorrichtung und/oder des Wärmeleitsystems von externer Energie weiter verringert. Der weiter verringerte Verbrauch von externer Energie geht mit weiter einer verringerten Umweltbelastung der zweiten Vorrichtung und/oder des Wärmeleitsystems einher.

Alternativ oder zusätzlich strömt das zweite Fluid von der zweiten Vorrichtung zu einem Wärmeakkumulator und von dem Wärmeakkumulator zu der zweiten Vorrichtung und zu dem thermoelektrischen Generator und erhöht der Wärmeakkumulator die Arbeitstemperatur und vergrößert der Wärmeakkumulator die Temperaturdifferenz. Das Wärmeleitsystem kann einen Wärmeakkumulator umfassen. Dank der mittels des Wärmeakkumulators vergrößerten Temperaturdifferenz erzeugt der thermoelektrische Generator mehr elektrische Energie. Auf diese Weise wird ein Verbrauch der zweiten Vorrichtung und/oder des Wärmeleitsystems von externer Energie weiter verringert. Der weiter verringerte Verbrauch von externer Energie geht mit einer weiter verringerten Umweltbelastung der zweiten Vorrichtung und/oder des Wärmeleitsystems einher.

Der Wärmeakkumulator kann einen Speicherbehälter für das zweite Fluid umfassen. Eine Speichertemperatur des in dem Speicherbehälter des Wärmeakkumulators gespeicherten zweiten Fluids, welche eine Menge von in dem Wärmeakkumulator gespeicherter Wärmeenergie angibt, darf eine maximale Kühltemperatur des zweiten Fluids, welche zum Kühlen der zweiten Vorrichtung gerade noch genügend niedrig ist, nicht überschreiten. Durch ein Einstellen der Speichertemperatur lässt sich ein Betriebspunkt des Wärmeleitsystems derart einstellen, dass bei einer höchstmöglichen unschädlichen Betriebstemperatur der zweiten Vorrichtung, d.h. einer gerade noch ausreichende Kühleffizienz des Wärmeleitsystems, eine höchstmögliche Eingangstemperatur des thermoelektrischen Generators erreicht wird.

Idealerweise werden der Wärmeakkumulator und der thermoelektrische Generator zum Erhöhen des Wirkungsgrads der zweiten Vorrichtung und/oder des Wärmeleitsystems und zum Verringern der Umweltbelastung miteinander derart kombiniert, dass das zweite Fluid aus der zweiten Vorrichtung erst durch den Wärmeakkumulator und dann durch die Solarthermieanlage zu dem thermoelektrischen Generator strömt.

In einer vorteilhaften Ausführungsform strömt das zweite Fluid von der zweiten Seite des Wärmeübertragers in einen Pufferspeicher des Wärmeleitsystems und von dem Pufferspeicher zu der zweiten Seite des Wärmeübertragers, zu dem Wärmeakkumulator und zu dem thermoelektrischen Generator. Der Pufferspeicher dient als ein Pufferspeicher und als eine hydraulische Weiche zwischen Unterkreisläufen des zweiten Kreislaufs. In seiner Funktion als ein Pufferspeicher ermöglicht er ein Einstellen der Speichertemperatur für den Wärmeakkumulator, wodurch eine Effizienz des Wärmeleitsystems optimiert wird. In seiner Funktion als hydraulische Weiche ermöglicht er ein Abstimmen von Volumenströmen in Unterkreisläufen des zweiten Kreislaufs.

Alternativ strömt in einer von der Normalbetriebsart verschiedenen Notbetriebsart des Wärmeleitsystems das zweite Fluid aus der zweiten Seite des Wärmeübertragers unmittelbar in die zweite Vorrichtung und aus der zweiten Vorrichtung unmittelbar zurück in die zweite Seite des Wärmetauschers. Die Notbetriebsart oder auch Wartungsbetriebsart des Wärmeleitsystems ist vorgesehen, um die zweite Vorrichtung zu kühlen, wenn ein Kühlen der zweiten Vorrichtung in der Normalbetriebsart beispielsweise wegen einer Wartung oder eines Ausfalls des Wärmeakkumulators, der Solarthermie, des elektromagnetischen Generators oder des Pufferspeichers nicht möglich ist. Dank der Notbetriebsart des Wärmeleitsystems weist das Kühlverfahren eine Redundanz und infolge der Redundanz eine hohe Verfügbarkeit auf.

Das Wärmeleitsystem umfasst vorteilhaft einen primären Wärmeübertrager ausschließlich für die Normalbetriebsart des Wärmeleitsystems und einen sekundären Wärmeübertrager ausschließlich für die Notbetriebsart des Wärmeleitsystems. In der Normalbetriebsart strömen das erste Fluid und das zweite Fluid durch den primären Wärmeübertrager. In der Notbetriebsart strömen das erste Fluid und das zweite Fluid durch den sekundären Wärmeübertrager.

In vielen Ausführungsformen erfasst ein Sensor des Wärmeleitsystems eine physikalischen Größe des Wärmeleitsystems, stellt eine Pumpe des Wärmeleitsystems einen Volumenstrom des ersten Fluids oder des zweiten Fluids ein und gibt ein Ventil des Wärmeleitsystems einen Fluss des ersten Fluids oder des zweiten Fluids frei oder sperrt den Fluss des ersten Fluids oder des zweiten Fluids und steuert eine Steuereinheit des Wärmeleitsystems die Pumpe und das Ventil abhängig von der erfassten physikalischen Größe. Die Steuereinheit ist mit jedem Sensor, jeder Pumpe und jedem Ventil des Wärmeleitsystems verbunden und steuert das Wärmeleitsystem durch Betätigen jeder Pumpe und jedes Ventils automatisch. Die Steuereinheit kann zum Steuern des Wärmeleitsystems einen oder mehrere Regelkreise definieren und die Pumpe und das Ventil entsprechend den definierten Regelkreisen steuern.

Das Wärmeleitsystem umfasst eine Mehrzahl von Sensoren zum Erfassen einer Temperatur, d.h. Temperatursensoren, als der physikalischen Größe umfassen. Im Einzelnen kann ein Temperatursensor eine Temperatur der Umgebung, eine Temperatur der ersten Vorrichtung, eine Temperatur der zweiten Vorrichtung oder eine Temperatur des ersten Fluids oder des zweiten Fluids erfassen. Entsprechend kann der Temperatursensor in der Umgebung, in der ersten Vorrichtung in der zweiten Vorrichtung, in dem Pufferspeicher, in dem Wärmeakkumulator, in der Solarthermieanlage oder in dem elektromagnetischen Generator angeordnet sein. Insbesondere kann ein Temperatursensor eine Temperatur eines Prozessors, eine Lufttemperatur eines Warmgangs oder eine Lufttemperatur eines Kaltgangs erfassen, wenn die zweite Vorrichtung als ein Rechenzentrum ausgebildet ist.

Ferner kann das Wärmeleitsystem eine Mehrzahl von Sensoren zum Erfassen eines Volumenstroms, d.h. Durchflusssensoren, als der physikalischen Größe umfassen. Im Einzelnen kann ein Durchflusssensor einen Volumenstrom des ersten Fluids oder des zweiten Fluids erfassen.

Weiterhin kann die Steuereinheit von der zweiten Vorrichtung einen Betriebsparameter, beispielsweise eine Prozessorlast, eine Leistungsaufnahme oder einen Kennwert, insbesondere einen Wirkungsgrad (Power Usage Effectiveness, PUE), empfangen und die Pumpe oder das Ventil abhängig von dem empfangenen Betriebsparameter steuern.

Ein weiterer Gegenstand der Erfindung ist ein Wärmeleitsystem zum Kühlen einer Vorrichtung, welches eine kontinuierlich zu betreibende einen ersten Wärmestrom bereitstellende erste Vorrichtung und eine einen zweiten Wärmestrom bereitstellende zweite Vorrichtung thermisch koppelt. Das Wärmeleitsystem ist ausgebildet, den zweiten Wärmestrom zu der ersten Vorrichtung zu leiten.

Das Wärmeleitsystem umfasst weder einen Kompressor noch einen Expander. Mit anderen Worten ist das Wärmeleitsystem ausgebildet, ein durch das Wärmeleitsystem strömendes Fluid weder zu komprimieren noch zu expandieren.

Das erfindungsgemäße Wärmeleitsystem ist konfiguriert, die zweite Vorrichtung mittels der ersten Vorrichtung durch Ausführen eines erfindungsgemäßen Verfahrens zu kühlen. Auf diese Weise stellt das Wärmeleitsystem sicher, dass die Umgebung der zweiten Vorrichtung keinen Wärmestrom und die Umgebung der ersten Vorrichtung höchstens einen über den ersten Wärmestrom hinausgehenden Anteil des zweiten Wärmestroms aufnehmen und eine Leistungsaufnahme der ersten Vorrichtung sinkt. Beide Wirkungen verringern eine thermische Belastung der Umwelt und wirken einer Klimaerwärmung entgegen.

Komponenten des Wärmeleitsystems, d.h. zumindest teilweise jeweils der erste Kreislauf oder der zweite Kreislauf, der Wärmeübertrager, der Wärmeakkumulator, die Solarthermieanlage, der thermoelektrische Generator und der Pufferspeicher können als eine kompakte Baugruppe ausgebildet sein. Die kompakte Baugruppe kann benachbart zu der ersten Vorrichtung oder benachbart zu der zweiten Vorrichtung angeordnet sein. Alternativ kann die kompakte Baugruppe auch in die erste Vorrichtung oder die zweite Vorrichtung räumlich integriert sein.

Ein wesentlicher Vorteil des erfindungsgemäßen Verfahrens besteht darin, dass die von der ersten Vorrichtung bereitgestellte Wärmeleistung weder eine Umgebung der ersten Vorrichtung und noch eine Umgebung der zweiten Vorrichtung erwärmt. Entsprechend ist ein zu der Wärmeleistung äquivalenter CO₂-Ausstoß der ersten Vorrichtung gering. Infolgedessen wird eine Umweltbelastung durch einen Betrieb der ersten Vorrichtung verringert oder vermieden. Weiterhin ist vorteilhaft, dass eine als erste Vorrichtung geeignete Vorrichtung zumeist bereits vorhanden ist, weshalb ein Implementieren des Verfahrens wirtschaftlich sehr günstig ist.

Weitere Vorteile und Merkmale der Erfindung werden nachfolgend anhand eines Ausführungsbeispiels und mit Bezugnahme auf die beliegenden Zeichnungen beschrieben. Darin zeigen
- Fig. 1: in einer schematischen Darstellung ein Wärmeleitsystem nach einer Ausführungsform der Erfindung zum Kühlen einer Vorrichtung;
- Fig. 2: in einer vergrößerten Detailansicht die von dem in Fig. 1 gezeigten Wärmeleitsystem zu kühlende zweite Vorrichtung;
- Fig. 3: in einer vergrößerten Detailansicht den Wärmeübertrager des in Fig. 1 gezeigten Wärmeleitsystems;
- Fig. 4: in einer vergrößerten Detailansicht den Wärmeakkumulator des in Fig. 1 gezeigten Wärmeleitsystems; und
- Fig. 5: in einer vergrößerten Detailansicht einen Wärmeakkumulator nach einer weiteren Ausführungsform der Erfindung.

In den Zeichnungen sind identische Komponenten mit identischen Bezugszeichen versehen.

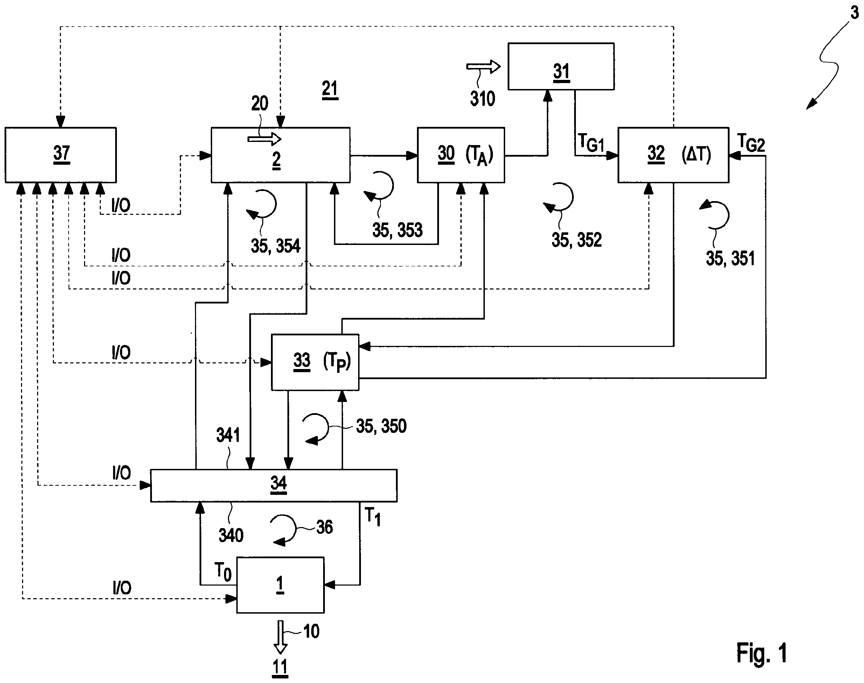

Fig. 1 zeigt in einer schematischen Darstellung ein Wärmeleitsystem 3 nach einer Ausführungsform der Erfindung zum Kühlen einer Vorrichtung. Das Wärmeleitsystem 3 koppelt eine erste Vorrichtung 1 und eine von der ersten Vorrichtung 1 verschiedene zweite Vorrichtung 2 thermisch.

Die erste Vorrichtung 1 ist in einer ersten Umgebung 11 angeordnet und ausgebildet, betriebsbedingt einen ersten Wärmestrom 10 bereitzustellen.

Die zweite Vorrichtung 2 ist von der ersten Vorrichtung 1 verschieden, in einer zweiten Umgebung 21 angeordnet und ausgebildet, betriebsbedingt einen zweiten Wärmestrom 20 bereitzustellen. Idealerweise ist die zweite Vorrichtung 2 mittels einer thermischen Isolierung von der zweiten Umgebung 21 thermisch entkoppelt. Die zweite Umgebung 21 kann beabstandet zu der ersten Umgebung 11 angeordnet sein, d.h. die zweite Vorrichtung 2 kann beabstandet zu der ersten Vorrichtung 1 angeordnet sein.

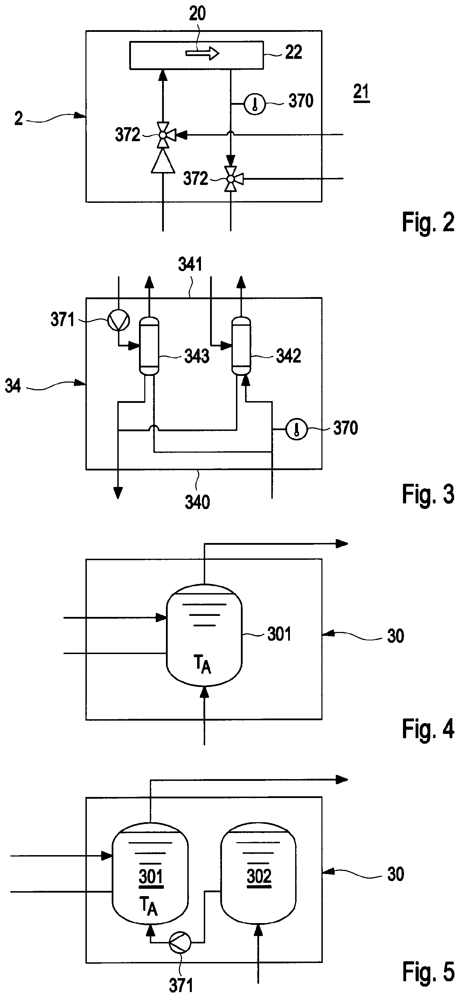

Fig. 2 zeigt in einer vergrößerten Detailansicht die von dem in Fig. 1 gezeigten Wärmeleitsystem 3 zu kühlende zweite Vorrichtung 2. Die zweite Vorrichtung 2 ist als ein Rechenzentrum ausgebildet. Das Rechenzentrum ist ausgebildet, als die zweite Vorrichtung 2 den zweiten Wärmestrom 20 bereitzustellen. Das Rechenzentrum umfasst eine Betriebseinrichtung 22 mit einer Mehrzahl von IT-Komponenten, beispielsweise Prozessoren, Datenspeichern, Netzwerkkomponenten und dergleichen, welche während eines Betriebs des Rechenzentrums den zweiten Wärmestrom 20 bereitstellen.

Ferner können in der zweiten Vorrichtung 2 zwei Ventile 372 des Wärmeleitsystems 3 angeordnet sein, welche über die Betriebseinrichtung 22 fluidverbunden sind. Die Ventile 372 sind beispielhaft als Drei-Wege-Ventile ausgebildet sind, können alternativ auch als Paare von Absperrventilen ausgebildet sein. In der zweiten Vorrichtung 2 kann zudem als ein Sensor 370 des Wärmeleitsystems 3 ein Temperatursensor zum Erfassen einer Temperatur des zweiten Kühlfluids angeordnet sein.

Zurückkommend auf Fig. 1, umfasst das Wärmeleitsystem 3 beispielhaft einen geschlossenen ersten Kreislauf 36 und einen von dem ersten Kreislauf 35 separaten geschlossenen zweiten Kreislauf 35. Der zweite Kreislauf 35 kann eine Mehrzahl von Unterkreisläufen 350, 351, 352, 353, 354 umfassen. Zu jedem Kreislauf 35, 36 gehört eine Mehrzahl von Rohrleitungen, welche von einer Umgebung der Kreisläufe 35, 36 mittels einer thermischen Isolierung thermisch entkoppelt sind, d.h. eine Umgebung der Kreisläufe 35, 36 nimmt keinen oder im Wesentlichen keinen von den Kreisläufen 35, 36 bereitgestellten Wärmestrom auf. Die Rohrleitungen sind jeweils als ein Verbindungspfeil dargestellt, wobei eine Richtung eines Verbindungspfeils eine Flussrichtung eines in dem jeweiligen Kreislauf strömenden Fluids angibt.

Das Wärmeleitsystem 3 umfasst ferner einen Wärmeübertrager 34 mit einer ersten Seite 340 und einer zweiten Seite 341. Die erste Vorrichtung 1 ist über den ersten Kreislauf 36 mit der ersten Seite des Wärmeübertagers 34 fluidverbunden. Die zweite Vorrichtung 2 ist über den zweiten Kreislauf 35 mit der zweiten Seite 341 des Wärmeübertragers 34 fluidverbunden. Die zweite Vorrichtung 2 ist insbesondere über den Unterkreislauf 354 unmittelbar mit der zweiten Seite 341 des Wärmetauschers 34 fluidverbunden.

Fig. 3 zeigt in einer vergrößerten Detailansicht den Wärmeübertrager 34 des in Fig. 1 gezeigten Wärmeleitsystems. Der Wärmeübertrager 34 kann einen primären Wärmeübertrager 342 und einen sekundären Wärmeübertrager 343 umfassen. Der primäre Wärmeübertrager 342 ist mit dem Unterkreislauf 350 fluidverbunden. Der sekundäre Wärmeübertrager 343 ist mit dem Unterkreislauf 354 fluidverbunden. Der Wärmeübertrager 34 kann eine Pumpe 371 zum Einstellen eines Volumenstroms des zweiten Fluids in dem Unterkreislauf 354 umfassen.

Der primäre Wärmeübertrager 342 und der sekundäre Wärmeübertrager 343 sind jeweils mit dem ersten Kreislauf 36 fluidverbunden. Der Wärmeübertrager kann ferner als einen Sensor 370 einen Temperatursensor zum Erfassen einer Temperatur des ersten Kühlfluids umfassen.

Zurückkommend auf Fig. 1, kann das Wärmeleitsystem 3 weiterhin einen thermoelektrischen Generator 32 zum Bereitstellen einer elektrischen Leistung umfassen. Die zweite Vorrichtung 2 ist über die Unterkreisläufe 352, 353 mit dem thermoelektrischen Generator 32 fluidverbunden. Der thermoelektrische Generator 32 ist über die Unterkreisläufe 350, 351 mit der zweiten Seite 341 des Wärmeübertragers 34 fluidverbunden. Der thermoelektrische Generator 32 kann die zum Bereitstellen der elektrischen Leistung erforderliche elektrische Energie mittels des Seebeck-Effekts, des Peltier-Effekts und/oder des Thomson-Effekts erzeugen.

Zu dem Wärmeleitsystem 3 kann ferner ein Wärmeakkumulator 30 gehören. Die zweite Vorrichtung 2 ist über den Unterkreislauf 353 mit dem Wärmeakkumulator 30 fluidverbunden. Der Wärmeakkumulator 30 ist über den Unterkreislauf 352 mit dem thermoelektrischen Generator 32 fluidverbunden. Bei Ausführungsformen ohne den Wärmeakkumulator 30 fallen die Unterkreisläufe 352 und 353 zusammen.

Fig. 4 zeigt in einer vergrößerten Detailansicht den Wärmeakkumulator 30 des in Fig. 1 gezeigten Wärmeleitsystems 3. Der Wärmeakkumulator 30 umfasst einen einzigen Speicherbehälter 301.

Fig. 5 zeigt in einer vergrößerten Detailansicht einen Wärmeakkumulator 30 nach einer weiteren Ausführungsform der Erfindung. Der Wärmeakkumulator 30 umfasst zwei Speicherbehälter 301, 302, welche miteinander fluidverbunden sind, und lediglich beispielhaft eine Pumpe 371, welche einen Volumenstrom des zweiten Fluids von dem Speicherbehälter 302 zu dem Speicherbehälter 301 einstellt. In anderen Ausführungsformen kann der Wärmeakkumulator 30 mehr als zwei kaskadenartig miteinander fluidverbundene Speicherbehälter umfassen.

Zurückkommend auf Fig. 1, kann das Wärmeleitsystem 3 zudem eine Solarthermieanlage 31 umfassen. Die Solarthermieanlage 31 ist vorteilhaft in den Unterkreislauf 352 fluidisch eingeschleift, d.h. mit einem Ausgang des Wärmeakkumulators 30 und einem Eingang des thermoelektrischen Generators 32 fluidverbunden. Die Solarthermieanlage 31 ist ausgebildet, einen von der Sonne verursachten dritten Wärmestrom 310 bereitzustellen.

Zu dem Wärmeleitsystem 3 kann auch ein Pufferspeicher 33 gehören. Der Pufferspeicher 33 kann - wie der Wärmeakkumulator 30 (s. Fig. 3, 4) - einen oder mehrere Speicherbehälter umfassen. Mehrere Speicherbehälter des Pufferspeichers 33 können kaskadenartig miteinander fluidverbunden sein.

Der Pufferspeicher 33 ist über den Unterkreislauf 350 mit der zweiten Seite 341 des Wärmeübertragers 34 fluidverbunden. Der thermoelektrische Generator 32 ist über den Unterkreislauf 351 mit dem Pufferspeicher 33 fluidverbunden. Die Vorrichtung 2 ist über den Wärmeakkumulator 30 und den Unterkreislauf 353 mit dem Pufferspeicher 33 fluidverbunden. Der Pufferspeicher kann jeweils eine Pumpe für den Unterkreislauf 350, für den Unterkreislauf 351 und für eine Zuleitung zu dem Wärmeakkumulator 30 umfassen. Bei Ausführungsformen ohne Pufferspeicher 33 fallen die Unterkreisläufe 350 und 351 zusammen und ist die zweite Vorrichtung 2 ggf. über den Wärmeakkumulator 30 mit der zweiten Seite 341 des Wärmeübertragers 34 fluidverbunden.

Das Wärmeleitsystem 3 umfasst idealerweise eine Mehrzahl von Sensoren 370 zum Erfassen einer physikalischen Größe des Wärmeleitsystems 3, eine Mehrzahl von Pumpen 371 zum Einstellen eines Volumenstroms des ersten Fluids oder des zweiten Fluids, eine Mehrzahl von Ventilen 372 zum Sperren oder Freigeben eines Flusses des ersten Fluids oder des zweiten Fluids und eine mit jedem Sensor 370, jeder Pumpe 371 und jedem Ventil 372 mittels einer elektrischer Leitung funktional verbundene Steuereinheit 37. Jeder Sensor 370 kann als ein Temperatursensor zum Erfassen einer Temperatur, ein Durchflusssensor zum Erfassen eines Volumenstroms oder ein Füllstandsensor zum Erfassen eines Füllstands ausgebildet sein. Die elektrischen Leitungen sind jeweils als ein Verbindungsdoppelpfeil dargestellt. Jeweils eine Richtung eines Verbindungspfeils gibt eine Richtung eines Steuersignals und die andere Richtung eines Verbindungspfeils gibt eine Richtung eines Sensorsignals an.

Das Wärmeleitsystem 3 umfasst für jeden Unterkreislauf 350, 351, 352, 353, 354 des zweiten Kreislaufs 35, für den ersten Kreislauf 36 sowie jede Leitung, welche nicht zu einem Kreislauf 36 oder Unterkreislauf 350, 351, 352, 353, 354 gehört, jeweils eine Pumpe 371. Jede Komponente des Wärmeleitsystems 3, d.h. der Wärmeakkumulator 30, die Solarthermieanlage 31, der thermoelektrische Generator 32, der Pufferspeicher 33 und der Wärmeübertrager 34 kann einen Temperatursensor als einen Sensor 370 umfassen. Zudem kann das Wärmeleitsystem 3 jeweils einen in der ersten Vorrichtung 1 und in der zweiten Vorrichtung 2 angeordneten Temperatursensor als einen Sensor 370 umfassen. Der Wärmeakkumulator 30 und der Pufferspeicher 33 können für jeden Speicherbehälter einen Füllstandsensor als einen Sensor 370 umfassen. Das Wärmeleitsystem 3 kann ferner für jeden Unterkreislauf 350, 351, 352, 353, 354 des zweiten Kreislaufs 35, den ersten Kreislauf 36 sowie jede Leitung, welche nicht zu einem Kreislauf 36 oder Unterkreislauf 350, 351, 352, 353, 354 gehört, einen Durchflusssensor als einen Sensor 370 umfassen.

Die Steuereinheit 37 ist mit der ersten Vorrichtung 1, der zweiten Vorrichtung 2 und dem Wärmeübertrager 34 jeweils mittels einer elektrischen Leitung funktional verbunden. Darüber hinaus kann die Steuereinheit 37 mit dem thermoelektrischen Generator 32, der Solarthermieanlage 31, dem Wärmeakkumulator 30 und dem Pufferspeicher 33 jeweils mittels einer elektrischen Leitung funktional verbunden sein. Genauer gesagt, ist die Steuereinheit 37 jeweils mit einem Sensor 370, einer Pumpe 371 oder einem Ventil 372 funktional verbunden, welche jeweils in der ersten Vorrichtung 1 oder der zweiten Vorrichtung 2 angeordnet sind oder zu dem Wärmeübertrager 34, dem thermoelektrischen Generator 32, der Solarthermieanlage 31, dem Wärmeakkumulator 30 oder dem Pufferspeicher 33 gehören.

Die Steuereinheit 37 und/oder die zweite Vorrichtung 2 können ferner über elektrische Leitungen mit dem thermoelektrischen Generator 32 energetisch verbunden sein. Die elektrischen Leitungen sind als Verbindungspfeile dargestellt. Eine Richtung eines Verbindungspfeils gibt jeweils eine Flussrichtung der von dem thermoelektrischen Generator 32 erzeugten elektrischen Energie an.

Falls die zweite Vorrichtung 2 die beiden Ventile 372 und der Wärmeübertrager 34 den primären Wärmeübertrager 342 und den sekundären Wärmeübertrager 343 umfasst, kann der zweite Kreislauf 35 abhängig von einer Stellung der beiden Ventile 372 wahlweise einen ersten Teilkreislauf, welcher aus dem Unterkreislauf 354 besteht, und einen zweiten Teilkreislauf mit den Unterkreisläufen 350, 351, 352, 353 umfassen.

Das Wärmeleitsystem 3 umfasst weder einen Kompressor noch einen Expander und ist ausgebildet, kein in dem Wärmeleitsystem 3 strömendes Fluid zu komprimieren oder zu expandieren.

Das Wärmeleitsystem 3 ist konfiguriert, zum Kühlen der zweiten Vorrichtung 2 mittels der ersten Vorrichtung 1 wie folgt betrieben zu werden.

Die erste Vorrichtung 1 wird bestimmungsgemäß kontinuierlich betrieben und stellt betriebsbedingt den ersten Wärmestrom 10 bereit. Die erste Umgebung 11 der ersten Vorrichtung 1 nimmt den ersten Wärmestrom 10 auf.

Die zweite Vorrichtung 2 wird üblicherweise kontinuierlich betrieben und stellt betriebsbedingt den zweiten Wärmestrom 20 bereit. Das Wärmeleitsystem 3 leitet zum Kühlen der zweiten Vorrichtung 2 den zweiten Wärmestrom 20 zu der ersten Vorrichtung 1. Dabei wird kein in dem Wärmeleitsystem strömendes Fluid komprimiert oder expandiert. Die erste Vorrichtung 1 nimmt den zweiten Wärmestrom 20 auf.

Als die erste Vorrichtung 1 wird eine Vorrichtung verwendet, welche eine Betriebsleistung korrespondierend zu dem zweiten Wärmestrom 20 automatisch verringert. Als die erste Vorrichtung 1 wird ein Trinkwassernetz verwendet. Das Trinkwassernetz ist ausgebildet, eine Betriebsleistung von an Verbrauchsstellen angeordneten Wassererwärmungseinrichtungen wie Heizungsanlagen oder Durchlauferhitzern korrespondierend zu dem zweiten Wärmestrom 20 automatisch zu verringern.

Jeder Sensor 370 des Wärmeleitsystems 3 erfasst eine physikalische Größe des Wärmeleitsystems 3. Die Steuereinheit 37 des Wärmeleitsystems 3 steuert jede Pumpe 371 und jedes Ventil 372 abhängig von den erfassten physikalischen Größen. Im Einzelnen stellt jede Pumpe 370 des Wärmeleitsystems 3 einen Volumenstrom des ersten Fluids oder des zweiten Fluids in dem zweiten Kreislauf 35 oder in dem ersten Kreislauf 36 ein und gibt jedes Ventil 372 des Wärmeleitsystems 3 einen Fluss des ersten Fluids oder des zweiten Fluids in dem zweiten Kreislauf 35 oder in dem ersten Kreislauf 36 frei oder sperrt einen Fluss des ersten Fluids oder des zweiten Fluids in dem zweiten Kreislauf 35 oder in dem ersten Kreislauf 36.

In jeder Betriebsart des Wärmeleitsystems 3 strömt in dem ersten Kreislauf 36 ein erstes Fluid von der Vorrichtung 1 mit einer Grundtemperatur T₀ zu der ersten Seite 340 des Wärmeübertragers 34, nimmt in dem Wärmeübertrager 34 den zweiten Wärmestrom 20 auf, und leitet den zweiten Wärmestrom 20 mit einer gegenüber der Grundtemperatur T₀ erhöhten Transporttemperatur T₁ den zweiten Wärmestrom 20 von der ersten Seite 340 des Wärmeübertragers 34 zu der ersten Vorrichtung 1. Die erste Seite 341 kann als die kalte Seite des Wärmeübertragers 34 bezeichnet werden. Bevorzugt wird Wasser als das erste Fluid und als das zweite Fluid verwendet, d.h. das erste Fluid und das zweite Fluid umfassen bevorzugt Wasser.

In dem zweiten Kreislauf 35 des Wärmeleitsystems 3 strömt ein zweites Fluid und leitet den zweiten Wärmestrom 20 von der zweiten Vorrichtung 2 zu der zweiten Seite 341 des Wärmeübertragers 34. Die zweite Seite 341 kann als die warme Seite des Wärmeübertragers 34 bezeichnet werden.

Das Wärmeleitsystem 3 kann in einer Normalbetriebsart betrieben werden. Dazu stellt die Steuereinheit 37 die Ventile 372 in der zweiten Vorrichtung 2 derart ein, dass die Betriebseinrichtung 22 der Vorrichtung 2 nicht unmittelbar mit der zweiten Seite 341 des Wärmeübertragers 34 fluidverbunden ist, d.h. das zweite Fluid strömt nicht in dem Unterkreislauf 354.

In der Normalbetriebsart des in Fig. 1 dargestellten Wärmeleitsystems 3 strömt das zweite Fluid jeweils von der zweiten Vorrichtung 2 und von der zweiten Seite 341 des Wärmeübertragers 34 zu dem thermoelektrischen Generator 32 und von dem thermoelektrischen Generator 32 zu der zweiten Seite 341 des Wärmeübertragers 34.

Der thermoelektrische Generator 32 erzeugt mittels einer Temperaturdifferenz ΔT zwischen einer ersten Eingangstemperatur T_{G1} des zweiten Fluids und einer zweiten Eingangtemperatur T_{G2} des zweiten Fluids, ΔT = T_{G1} - T_{G2}, eine elektrische Leistung und stellt die erzeugte elektrische Leistung zum Betreiben des Wärmeleitsystems 3 und/ oder der zweiten Vorrichtung 2 bereit.

Im Einzelnen strömt das zweite Fluid zunächst von der zweiten Vorrichtung 2 zu dem Wärmeakkumulator 30 und von dem Wärmeakkumulator 30 zurück zu der zweiten Vorrichtung 2, d.h. das zweite Fluid strömt in dem Unterkreislauf 353. Das in dem Wärmeakkumulator 30 angeordnete zweite Fluid weist eine Speichertemperatur T_{A} auf, welche einer in dem Wärmeakkumulator 30 gespeicherten Wärme entspricht. Es versteht sich, dass während einer Anlaufphase des Verfahrens die in dem Wärmeakkumulator 30 gespeicherte Wärme allmählich zunimmt und eine Temperatur des in dem Wärmeakkumulator 30 angeordneten zweiten Fluids während der Anlaufphase auf die Speichertemperatur T_{A} ansteigt. Der Wärmeakkumulator 30 erhöht die erste Eingangstemperatur T_{G1} des thermoelektrischen Generators und vergrößert die Temperaturdifferenz ΔT.

Das zweite Fluid strömt von der zweiten Vorrichtung 2, genauer gesagt von dem Wärmeakkumulator 30, zu der den dritten Wärmestrom 310 bereitstellenden Solarthermieanlage 31, nimmt in der Solarthermieanlage 31 den dritten Wärmestrom 310 auf, und strömt von der Solarthermieanlage 31 zu dem thermoelektrischen Generator 32. Die Solarthermieanlage 31 erhöht die erste Eingangstemperatur T_{G1} und vergrößert die Temperaturdifferenz ΔT.

Das zweite Fluid kann von der zweiten Seite 341 des Wärmeübertragers 34 in den Pufferspeicher 33 des Wärmeleitsystems 3 strömen und aus dem Pufferspeicher 33 zu der zweiten Seite 341 des Wärmeübertragers 34, zu dem Wärmeakkumulator 30 und zu dem thermoelektrischen Generator 32 strömen. Das in dem Pufferspeicher 33 angeordnete zweite Fluid weist eine Puffertemperatur T_{P} auf, welche einer in dem Pufferspeicher 30 gespeicherten Wärme entspricht und geringer ist als die Speichertemperatur T_{A}. Es versteht sich, dass während einer Anlaufphase des Verfahrens die in dem Pufferspeicher 33 gespeicherte Wärme allmählich zunimmt und eine Temperatur des in dem Pufferspeicher 33 angeordneten zweiten Fluids während der Anlaufphase auf die Puffertemperatur T_{P} ansteigt.

Das Wärmeleitsystem 3 kann alternativ zu der Normalbetriebsart in einer von der Normalbetriebsart verschiedenen Notbetriebsart oder auch Wartungsbetriebsart betrieben werden. Dazu stellt die Steuereinheit 37 die Ventile 372 in der zweiten Vorrichtung 2 derart ein, dass die Betriebseinrichtung 22 der Vorrichtung 2 unmittelbar mit der zweiten Seite 341 des Wärmeübertragers 34 fluidverbunden ist.

In der Notbetriebsart strömt das zweite Fluid von der zweiten Seite 341 des Wärmeübertragers 34 unmittelbar zu der zweiten Vorrichtung 2 und von der zweiten Vorrichtung 2 unmittelbar zu der zweiten Seite 341 des Wärmetauschers 34, d.h. das zweite Fluid strömt ausschließlich in dem Unterkreislauf 354.

Ein Wirkungsgrad der Notbetriebsart ist grundsätzlich gleich dem Wirkungsgrad der Normalbetriebsart, falls das Wärmeleitsystem 3 keinen Wärmeakkumulator 30, keine Solarthermieanlage 31, keinen thermoelektrischen Generator 32 und keinen Pufferspeicher 33 umfasst und die Unterkreisläufe 350, 351, 352, 353 zusammenfallen.

### BEZUGSZEICHEN

- 1: erste Vorrichtung
- 10: erster Wärmestrom
- 11: erste Umgebung
- 2: zweite Vorrichtung
- 20: zweiter Wärmestrom
- 21: zweite Umgebung
- 22: Betriebseinrichtung
- 3: Wärmeleitsystem
- 30: Wärmeakkumulator
- 301: Speicherbehälter
- 302: Speicherbehälter
- 31: Solarthermieanlage
- 310: dritter Wärmestrom
- 32: thermoelektrischer Generator
- 33: Pufferspeicher
- 34: Wärmeübertrager
- 340: erste Seite
- 341: zweite Seite
- 342: primärer Wärmeübertrager
- 343: sekundärer Wärmeübertrager
- 35: zweiter Kreislauf
- 350: Unterkreislauf
- 351: Unterkreislauf
- 352: Unterkreislauf
- 353: Unterkreislauf
- 354: Unterkreislauf
- 355: Unterkreislauf
- 36: erster Kreislauf
- 37: Steuereinheit
- 370: Sensor
- 371: Pumpe
- 372: Ventil
- T₀: Grundtemperatur
- T₁: Transporttemperatur
- T_{G1}: erste Eingangstemperatur
- T_{G2}: zweite Eingangstemperatur
- ΔT: Temperaturdifferenz
- T_{A}: Speichertemperatur
- T_{P}: Puffertemperatur

## Patentansprüche

1. Verfahren zum Kühlen einer Vorrichtung (2), bei dem
- eine kontinuierlich betriebene erste Vorrichtung (1) betriebsbedingt einen ersten Wärmestrom (10) bereitstellt;
- eine Umgebung (11) der ersten Vorrichtung (1) den ersten Wärmestrom (10) aufnimmt;
- eine von der ersten Vorrichtung (1) verschiedene zweite Vorrichtung (2) betriebsbedingt einen zweiten Wärmestrom (20) bereitstellt, wobei als die zweite Vorrichtung (2) ein Rechenzentrum den zweiten Wärmestrom (20) bereitstellt;
- ein die zweite Vorrichtung (2) und die erste Vorrichtung (1) thermisch koppelndes Wärmeleitsystem (3) zum Kühlen der zweiten Vorrichtung (2) den zweiten Wärmestrom (20) zu der ersten Vorrichtung (1) leitet, wobei kein in dem Wärmeleitsystem (3) strömendes Fluid komprimiert oder expandiert wird;
- die erste Vorrichtung (1) den zweiten Wärmestrom (20) aufnimmt; und bei dem
- als die erste Vorrichtung (1) ein Trinkwassernetz verwendet wird, welches den zweiten Wärmestrom (20) aufnimmt und eine Betriebsleistung korrespondierend zu dem zweiten Wärmestrom (20) automatisch verringert.

2. Verfahren nach Anspruch 1, bei dem ein in einem geschlossenen zweiten Kreislauf (35) des Wärmeleitsystems (3) strömendes zweites Fluid den zweiten Wärmestrom (20) von der zweiten Vorrichtung (2) zu einer zweiten Seite (341) eines Wärmeübertragers (34) des Wärmeleitsystems (3) leitet und ein in einem von dem zweiten Kreislauf (35) separaten geschlossenen ersten Kreislauf (36) des Wärmeleitsystems (3) strömendes erstes Fluid den zweiten Wärmestrom (20) von einer ersten Seite (340) des Wärmeübertragers (34) zu der ersten Vorrichtung (1) leitet.

3. Verfahren nach Anspruch 2, bei dem in einer Normalbetriebsart des Wärmeleitsystems (3) das zweite Fluid von der zweiten Vorrichtung (2) und von der zweiten Seite (341) des Wärmeübertragers (34) zu einem thermoelektrischen Generator (32) des Wärmeleitsystems (3) und von dem thermoelektrischen Generator (32) zu der zweiten Seite (341) des Wärmeübertragers (34) strömt und der thermoelektrische Generator (32) mittels einer Temperaturdifferenz (ΔT) zwischen einer ersten Eingangstemperatur (T_{G1}) des zweiten Fluids und einer zweiten Eingangtemperatur (T_{G2}) des zweiten Fluids eine elektrische Leistung erzeugt und die erzeugte elektrische Leistung zum Betreiben des Wärmeleitsystems (3) und/oder der zweiten Vorrichtung (2) bereitstellt.

4. Verfahren nach Anspruch 3, bei dem das zweite Fluid von der zweiten Vorrichtung (2) zu einer einen dritten Wärmestrom (310) bereitstellenden Solarthermieanlage (31) und von der Solarthermieanlage (31) zu dem thermoelektrischen Generator (32) strömt und die Solarthermieanlage (31) die erste Eingangstemperatur (T_{G1}) erhöht und die Temperaturdifferenz (ΔT) vergrößert.

5. Verfahren nach Anspruch 3 oder 4, bei dem das zweite Fluid von der zweiten Vorrichtung (2) zur einem Wärmeakkumulator (30) und von dem Wärmeakkumulator (30) zu der zweiten Vorrichtung (2) und zu dem thermoelektrischen Generator (32) strömt und der Wärmeakkumulator (30) die erste Eingangstemperatur (T_{G1}) erhöht und die Temperaturdifferenz (ΔT) vergrößert.

6. Verfahren nach einem der Ansprüche 3 bis 5, bei dem das zweite Fluid von der zweiten Seite (341) des Wärmeübertragers (34) in einen Pufferspeicher (33) des Wärmeleitsystems (3) und aus dem Pufferspeicher (33) zu der zweiten Seite (341) des Wärmeübertragers (34), zu dem Wärmeakkumulator (30) und zu dem thermoelektrischen Generator (32) strömt.

7. Verfahren nach einem der Ansprüche 1 bis 6, bei dem in einer von der Normalbetriebsart verschiedenen Notbetriebsart des Wärmeleitsystems (3) das zweite Fluid von der zweiten Seite (341) des Wärmeübertragers (34) unmittelbar zu der zweiten Vorrichtung (2) und von der zweiten Vorrichtung (2) unmittelbar zu der zweiten Seite (341) des Wärmetauschers (34) strömt.

8. Verfahren nach einem der Ansprüche 1 bis 7, bei dem ein Sensor (370) des Wärmeleitsystems (3) einen physikalische Größe des Wärmeleitsystems (3) erfasst, eine Pumpe (371) des Wärmeleitsystems (3) einen Volumenstrom des ersten Fluids oder des zweiten Fluids einstellt und ein Ventil (372) des Wärmeleitsystems (3) einen Fluss des ersten Fluids oder des zweiten Fluids freigibt oder sperrt und eine Steuereinheit (37) des Wärmeleitsystems (3) die Pumpe (371) und das Ventil (372) abhängig von den erfassten physikalischen Größen steuert.

9. Wärmeleitsystem (3) zum Kühlen einer Vorrichtung (2), welches eine bestimmungsgemäß kontinuierlich zu betreibende erste Vorrichtung (1) und eine zweite Vorrichtung (2) thermisch koppelt und konfiguriert ist, die zweite Vorrichtung (2) mittels der ersten Vorrichtung (1) durch Ausführen eines Verfahrens nach einem der Ansprüche 1 bis 8 zu kühlen.

## Claims

1. A method for cooling a device (2), wherein
- a first device (1) being operated continuously provides a first heat flow (10) caused by the operation;
- a surrounding of the first device (1) absorbs the first heat flow (10);
- a second device (2) different from the first device (1) provides a second heat flow (20) caused by an operation, a data center providing the second heat flow (20) as the second device (2);
- a heat conduction system (3) thermally coupling the second device (2) and the first device (1) conducts the second heat flow (20) to the first device (1) with no fluid flowing within the heat conduction system (3) being compressed or expanded;
- the-first device (1) absorbs the second heat flow (20); and wherein
- a drinking water network is used as the first device (1) which absorbs the second heat flow (20) and automatically reduces an operating power corresponding to the second heat flow (20).

2. The method according to claim 1, wherein a second fluid flowing in a second closed cycle (35) of the heat conduction system (3) conducts the second heat flow (20) from the second device (2) to a second side (341) of a heat exchanger (34) of the heat conduction system (3) and a first fluid flowing in a first closed cycle (36) of the heat conduction system (3) separate from the second closed cycle (35) conducts the second heat flow (20) from a first side (340) of the heat exchanger (34) to the first device (1).

3. The method according to claim 2, wherein the second fluid flows from the second device (2) and from the second side (341) of the heat exchanger (34) to a thermo-electric generator (32) of the heat conduction system (3) and from the thermo-electric generator (32) to the second side (341) of the heat exchanger (34) in a normal operational mode of the heat conduction system (3) and the thermo-electric generator (32) generates an electric power by means of a temperature difference (ΔT) between a first input temperature (T_{G1}) and a second input temperature (T_{G2}) and provides the generated electric power for operating the heat conduction system (3) and/or the second device (2).

4. The method according to claim 3, wherein the second fluid flows from the second device (2) to a solar heating system (31) providing a third heat flow (310) and from the solar heating system (31) to the thermo-electric generator (32) and the solar heating system (31) increases the first input temperature (T_{G1}) and the temperature difference (ΔT).

5. The method according to claim 3 or 4, wherein the second fluid flows from the second device (2) to a heat accumulator (30) and from the heat accumulator (30) to the second device (2) and to the thermo-electric generator (32) and the heat accumulator (30) increases the first input temperature (T_{G1}) and the temperature difference (ΔT).

6. The method according to one of claims 3 to 5, wherein the second fluid flows from the second side (341) of the heat exchanger (34) into a buffer tank (33) of the heat conduction system (3) and from the buffer tank (33) to the second side (341) of the heat exchanger (34), to the heat accumulator (30) and to the thermo-electric generator (32).

7. The method according to one of claims 1 to 6, wherein the second fluid flows from the second side (341) of the heat exchanger (34) immediately to the second device (2) and from the second device (2) immediately to the second side (341) of the heat exchanger (34) in an emergency operational mode of the heat conduction system (3) different from the normal operational mode.

8. The method according to one of claims 1 to 7, wherein a sensor (370) of the heat conduction system (3) captures a physical quantity of the heat conducting system (3), a pump (371) of the heat conduction system (3) adjusts a volume flow of the first fluid or the second fluid and a valve (372) of the heat conduction system (3) allows or prevents a flow of the first fluid or the second fluid and a control unit (37) of the heat conduction system (3) controls the pump (371) and the valve (372) depending on the captured physical quantity.

9. A heat conduction system (3) for cooling a device (2), thermally coupling a first device (1) intended to be operated continuously and a second device (2) and configured for cooling the second device (2) by means of the first device (1) by carrying out a method according to one of claims 1 to 8.

## Revendications

1. - Procédé pour le refroidissement d'un dispositif (2), dans lequel :
- un premier dispositif (1) fonctionnant en continu fournit un premier flux de chaleur (10) en raison du fait qu'il est actionné ;
- un environnement (11) du premier dispositif (1) reçoit le premier flux de chaleur (10) ;
- un second dispositif (2), différent du premier dispositif (1), fournit un second flux de chaleur (20) en raison du fait qu'il est actionné, un centre de données fournissant le second flux de chaleur (20) en tant que second dispositif (2) ;
- un système de conduction thermique (3) couplant thermiquement le second dispositif (2) et le premier dispositif (1) conduit le second flux de chaleur (20) au premier dispositif (1) pour le refroidissement du second dispositif (2), aucun fluide circulant dans le système de conduction thermique (3) n'étant comprimé ou dilaté ;
- le premier dispositif (1) reçoit le second flux de chaleur (20) ; et dans lequel
- un réseau d'eau potable est utilisé comme premier dispositif (1), lequel reçoit le second flux de chaleur (20) et réduit automatiquement une puissance de fonctionnement correspondant au second flux de chaleur (20) .

2. - Procédé selon la revendication 1, dans lequel un second fluide circulant dans un second circuit fermé (35) du système de conduction thermique (3) conduit le second flux de chaleur (20) du second dispositif (2) au second côté (341) d'un échangeur de chaleur (34) du système de conduction thermique (3) et un premier fluide circulant dans un premier circuit fermé (36) du système de conduction thermique (3), séparé du second circuit (35), conduit le second flux de chaleur (20) d'un premier côté (340) de l'échangeur de chaleur (34) au premier dispositif (1).

3. - Procédé selon la revendication 2, dans lequel, dans un mode de fonctionnement normal du système de conduction thermique (3), le second fluide circule du second dispositif (2) et du second côté (341) de l'échangeur de chaleur (34) au générateur thermoélectrique (32) du système de conduction thermique (3) et du générateur thermoélectrique (32) au second côté (341) de l'échangeur de chaleur (34), et le générateur thermoélectrique (32) génère une puissance électrique au moyen d'une différence de température (ΔT) entre une première température d'entrée (T_{G1}) du second fluide et une seconde température d'entrée (T_{G2}) du second fluide et fournit la puissance électrique générée pour faire fonctionner le système de conduction thermique (3) et/ou le second dispositif (2).

4. - Procédé selon la revendication 3, dans lequel le second fluide circule du second dispositif (2) à une installation solaire thermique fournissant un troisième flux de chaleur (310) et de l'installation solaire thermique (31) au générateur thermoélectrique (32), et l'installation solaire thermique (31) élève la première température d'entrée (T_{G1}) et augmente la différence de température (ΔT).

5. - Procédé selon l'une des revendications 3 ou 4, dans lequel le second fluide circule du second dispositif (2) à un accumulateur de chaleur (30) et de l'accumulateur de chaleur (30) au second dispositif (2) et au générateur thermoélectrique (32), et l'accumulateur de chaleur (30) élève la première température d'entrée (T_{G1}) et augmente la différence de température (ΔT).

6. - Procédé selon l'une des revendications 3 à 5, dans lequel le second fluide circule du second côté (341) de l'échangeur de chaleur (34) à un tampon de stockage (33) du système de conduction thermique (3) et du tampon de stockage (33) au second côté (341) de l'échangeur de chaleur (34), à l'accumulateur de chaleur (30) et au générateur thermoélectrique (32).

7. - Procédé selon l'une des revendications 1 à 6, dans lequel, dans un mode de fonctionnement d'urgence, différent du mode de fonctionnement normal, du système de conduction thermique (3), le second fluide circule du second côté (341) de l'échangeur de chaleur (34) directement au second dispositif (2) et du second dispositif (2) directement au second côté (341) de l'échangeur de chaleur (34).

8. - Procédé selon l'une des revendications 1 à 7, dans lequel un capteur (370) du système de conduction thermique (3) détecte une grandeur physique du système de conduction thermique (3), une pompe (371) du système de conduction thermique (3) règle un débit volumétrique du premier fluide ou du second fluide et une soupape (372) du système de conduction thermique (3) libère ou bloque un écoulement du premier fluide ou du second fluide et une unité de commande (37) du système de conduction thermique (3) commande la pompe (371) et la soupape (372) en fonction des grandeurs physiques détectées.

9. - Système de conduction thermique (3) pour le refroidissement d'un dispositif (2), lequel couple thermiquement un premier dispositif (1) à faire fonctionner en continu conformément à sa destination et un second dispositif (2) et est configuré pour refroidir le second dispositif (2) au moyen du premier dispositif (1) par la mise en œuvre d'un procédé selon l'une des revendications 1 à 8.
